# EUROPEAN PATENT APPLICATION

(11) **EP 3 121 308 A1**
(43) Date of publication of application: **25.01.2017**
(21) Application number: 16179641.2
(22) Date of filing: 15.07.2016
(51) Int. Cl.: C23C 14/02, C23C 14/04, C23C 14/56, C23C 14/58

(54) **METHOD AND MACHINE FOR TREATING SMALL OBJECTS**

(30) Priority: 20.07.2015 IT UB20152328
(71) Applicant: TAPEMATIC S.p.A., 20876 Ornago (Monza Brianza) (IT)
(72) Inventor: PEREGO, Luciano, 23807 MERATE (LECCO) (IT)
(74) Representative: Tansini, Elio Fabrizio

(57) **Abstract**

Method for the decoration of small three-dimensional objects (1, 1 a) comprising the steps of: providing a semi-finished three-dimensional object (2) to be treated comprising a support (10); by means of physical vapor deposition (PVD), realizing on at least one surface (5) of said support (10) a metallization layer (12) comprising a three-dimensional figure (15, 15a), said three-dimensional figure (15, 15a) comprising a plurality of reliefs and/or recesses (20, 21). A three-dimensional impression (16, 16a) is provided on at least one surface (5) of said support, comprising a plurality of projections and/or cavities (18, 19), for which the metallization layer realized by means of the PVD treatment presents a three-dimensional figure (15, 15a), comprising a plurality of reliefs and/or recesses (20, 21) respectively in correspondence of said projections and cavities (18, 19). The three-dimensional impression (16, 16a) is obtained by means of a laser marking treatment.

## Description

The present invention refers to a method for the treatment, for example the decoration, of small three-dimensional objects, such as perfume bottles, caps, and the like, whose typical dimensions are in the order of a few centimetres (2 - 10 cm).

The present invention refers to a machine for the execution of a method for the treatment of small three-dimensional objects.

The present invention finally refers to a small three-dimensional object obtainable by the method and the machine defined above.

In the technical field of the production of small three-dimensional objects, such as perfume bottles, caps and the like, the application of metallization layers to one or more external surfaces in view of the manufactured object is known.

Metallizing is a process of surface finish which can transform significantly the surface of the artefact by embellishing and enhancing its appearance, so that a simple print takes on more sophisticated and more precious semblances. Metallizing makes it possible to perfectly imitate other types of colours, for example those obtained through the process of galvanic baths, thus allowing to make items made of low-quality plastic or metallic material aesthetically similar to higher-value (for example chrome or gold-plated) items.

The metallization layer is obtainable by means of "sputtering" (cathode pulverization). Such technique is achieved through the emission of atoms, ions or molecular fragments from a solid material, known as target, bombarded with a beam of energetic particles, usually an ion plasma. The ion plasma strikes the target that, due to the collision, releases atoms and particles that are re-condensed on the surfaces of the object to be coated.

This process is carried out in a vacuum chamber.

The proper implementation of metallization by means of sputtering technique typically requires that the surfaces to be metallized are first coated with a primer layer to cover any surface imperfections which could compromise the subsequent metallization step.

After the metallization step, the metallized surfaces may be further subjected to a painting process to be coated with a finishing protective layer (transparent or with additional colouring). The final layer can have in particular the function of protecting the metallization layer from oxidation or providing a particular aesthetic effect to the final metallized surfaces.

Methods of the type mentioned above are for example described in detail in US 2012/0234670 or US 2014/0034482.

Although the above-mentioned methods can realize desired surfaces having the desired aspect in several cases, however, in this technical field, the need is still felt to provide methods for the decoration of small objects which are able to confer a wider range of surface and/or visual effects to the surfaces of such objects, with the possible integration of graphical and/or encoded information. The need is also felt to provide small objects, for example packages of pharmaceutical and/or cosmetic products, with new features suitable to introduce anti-counterfeiting identifying elements.

In this context, the technical task underlying the present invention is to overcome the limitations encountered in the prior art.

The technical task mentioned and the objects stated are substantially achieved by a method and a machine for the treatment of small three-dimensional objects and by a small three-dimensional object, comprising the technical features set out in one or more of the appended claims.

More particularly, according to a first aspect, the invention refers to a method for the treatment of small three-dimensional objects comprising the steps of: providing a semi-finished three-dimensional objects to be treated comprising a support; realizing on at least one surface of said support a metallization layer comprising a three-dimensional figure, for example a decoration, said three-dimensional figure comprising a plurality of reliefs and/or recesses. The realization of a three-dimensional impression on at least one of said support surfaces is also preferably provided for. Said three-dimensional impression provides a plurality of projections and/or cavities, for which the realized metallization layer presents a three-dimensional figure, comprising a plurality of reliefs and/or recesses respectively in correspondence of said projections and cavities. Preferably, said three-dimensional impression is obtained by a laser etching or marking treatment.

Preferably, the metallization layer is realized by sputtering or other physical vapor deposition (PVD) treatment.

Physical vapor deposition processes, more simply called PVD, are deposition processes wherein material is evaporated from a solid or liquid source in the form of atoms or molecules and transported in vapor form through a vacuum environment or plasma, up to the substrate where the material condensates.

In accordance with a further aspect, the invention refers to a machine for the treatment of small three-dimensional objects comprising a plurality of operational stations including: a supply station adapted to receive a three-dimensional object to be treated, said three-dimensional object comprising semi-finished support; a metallizing station for arranging a metallization layer on a surface of said support. Said metallizing station preferably comprises a physical vapor deposition (PVD) chamber, for example a sputtering chamber, to deposit said metallization layer with a substantially uniform thickness on said support. Processing devices are also provided, comprising a laser etching or marking unit for realizing a three-dimensional impression on said at least one surface, comprising a plurality of projections and/or cavities. The metallization layer realized in the metallizing station therefore presents a three-dimensional figure, for example a decoration, comprising a plurality of reliefs and/or recesses in correspondence of said projections and cavities, respectively.

According to a further aspect, the invention proposes a three-dimensional small object comprising: a support; a possible base layer in contact with a surface of said support; a metallization layer preferably formed by a PVD treatment, for example sputtering, in contact with said surface or of the possible base layer, said metallization layer comprising a three-dimensional figure, for example a decoration, said three-dimensional figure comprising a plurality of reliefs and/or recesses; a possible final coating layer above said metallization layer, said final coating layer preferably being devoid of reliefs and/or recesses corresponding to said three-dimensional figure.

In at least one of the above aspects, the invention comprises one or more of the following preferred features.

Preferably, the realization of said three-dimensional impression occurs before the realization of said metallization layer.

Preferably, said three-dimensional impression is realized on a base layer previously applied in contact with said at least one surface of the support. Preferably, said three-dimensional figure is obtained by plastic deformation of the base layer.

Plastic deformation preferably occurs due to the laser etching or marking treatment.

The use of laser etching or marking on the base layer allows to obtain, if necessary, a three-dimensional impression in relief. It is in fact possible to choose, for the realization of the base layer, materials suitable for undergoing a permanent localized swelling in the areas affected by the laser radiation.

Preferably, the plastic deformation is carried out by pressing against the base layer a mould on which a three-dimensional negative impression is obtained, i.e. a complementary impression to the same three-dimensional impression, but with reversed projections and recesses, respectively.

Preferably, the three-dimensional negative impression is made by laser etching or marking.

Preferably, said base layer is applied by a lacquering or painting operation and subsequent pre-drying, before providing said three-dimensional impression on said base layer.

Preferably, between said step of providing said three-dimensional impression and said step of forming said metal layer, there is a step of total drying of the base layer.

Preferably, the application of the base layer is performed by means of the "UV coating" procedure.

Preferably, the step of removing portions of said metallization layer to obtain said three-dimensional figure is performed.

Preferably, the removal of portions of said metallization layer in order to obtain said three-dimensional figure is performed by laser etching or marking.

The material ablated by laser etching or marking is preferably removed, for example by suction.

Preferably, said support is made of transparent material.

Preferably, after said step of providing said metallization layer with the three-dimensional shape, there is a step of applying a final coating layer on said metallization layer.

Preferably, the final coating layer can be provided with reliefs and/or recesses corresponding to said three-dimensional figure. In this way, a low-relief effect detectable to the touch is obtained.

Alternatively, the final coating layer can be provided with no reliefs and/or recesses corresponding to said three-dimensional figure.

Preferably, the metallization layer is realized on a base layer previously applied in contact with said surface of the support.

Preferably, said processing devices operate upstream of said metallizing station.

Preferably, upstream of said metallizing station is provided a painting and drying assembly including: a lacquering or painting station for applying a base layer in contact with said surface of said support; a downstream drying station of said lacquering or painting station.

Preferably, said laser etching or marking unit operates downstream of the painting and drying assembly.

Preferably, between the lacquering or painting station and the drying station, a processing station is provided for the base layer, in order to provide said three-dimensional impression.

Preferably, the base layer processing station includes plastic deformation devices of said base layer.

Preferably, said painting and drying assembly further includes a pre-drying station, arranged between the lacquering or painting station and the processing station.

Preferably, said processing devices also operate downstream of said physical vapor deposition (PVD) chamber.

Preferably, downstream of said metallization station, a finishing station is provided to apply a final coating layer on said metallization layer.

Further features and advantages of the present invention will become more apparent from the indicative description, and therefore not limited to a preferred but not exclusive embodiment of a method and a machine for the treatment of small three-dimensional objects and by a small three-dimensional object, as illustrated in the appended drawings, in which:
- Figure 1 is an axonometric view of a semi-finished three-dimensional object to be treated according to the present invention;
- Figure 2 is an axonometric view of a small three-dimensional object according to the present invention;
- Figure 3 represents an elevated view of the three-dimensional object of Figure 2;
- Figure 4 is a partial sectional view of the small three-dimensional object of Figure 2, according to the section line IV-IV of Figure 3;
- Figure 5 is a partial sectional view of the small three-dimensional object of Figure 2, according to the section line V-V of Figure 3;
- Figure 6 is an axonometric view of a possible alternative embodiment of the three-dimensional object of Figure 2;
- Figure 7 represents an elevational view of the three-dimensional object of Figure 6;
- Figure 8 is a partial sectional view of the small three-dimensional object of Figure 6, according to the section line VIII-VIII of Figure 7;
- Figure 9 is a schematic elevational view of a machine for the treatment of small three-dimensional objects according to the present invention;
- Figures 10 and 11 represent two schematic elevational views of two respective possible embodiments of the machine of Figure 9.

With reference to the accompanying drawings, two decorated plastic caps 1, 1 a, which can be obtained by the present invention, are described below.

In general, the invention allows the realization of a multitude of decorated three-dimensional objects such as, for example, in addition to the above mentioned caps, perfume bottles and the like, whose typical dimensions are in the order of a few centimetres (2 - 10 cm). In the attached figures and in the description that follows, similar or identical elements, even when they belong to different embodiments of the invention, are indicated with the same reference numeral.

The plastic cap 1, 1 a is obtained by the treatment of a surface 5 of a semi-finished three-dimensional cap 2, consists of a moulded plastic item comprising a cylindrical shank 3 and a head 10, also cylindrical. The shank 3 is capable of being inserted through the opening of a bottle for closing the same. The head 10 is susceptible to protrude from the same bottle and constitutes a support for the realization of the treatment described below.

The head, or support 10 comprises the surface 5 to be treated, for example to be decorated, according to the steps of the method described below.

The description that follows is applicable in general to a plurality of supports 10 comprising respective surfaces 5 to be treated, i.e. also supports 10 with surfaces 5 to be treated other than plastic caps.

The present invention is also applicable to supports in a material different from plastic, such as metal material supports.

The treatment method of small three-dimensional objects 1, 1 a according to the present invention includes, after a preliminary step of providing the semi-finished three-dimensional object 2 comprising the support 10, the step of applying a base layer 11, or primer, to the contact surface 5. The surface 5, in particular when the support 10 is obtained by moulding a plastic material, may typically comprise a plurality of scratches, irregularities or other defects, that the base layer 11 has the function of covering.

According to possible embodiments of the present invention, the base layer 11 is obtained by lacquering or painting, that is by spreading a layer 11 of lacquer or paint over the surface 5.

According to a possible alternative embodiment of the present invention, the lacquer or paint may be applied by a "UV coating" method, that is a process substantially involving the application of a resin or paint layer 11 and, subsequently, the hardening by cross-linking of the same layer, through irradiation with ultraviolet light.

According to a possible alternative embodiment of the present invention, after the application of the base layer 11, there is a pre-drying step, for example by application of infrared or ultraviolet rays. The pre-drying or partial solidification step has the task of preparing the base layer 11, making it processable, for the subsequent step of providing a three-dimensional impression 16, 16a on the base layer 11. The three-dimensional impression 16, 16a constitutes the basic shape to the above which may be applied subsequently to a respective three-dimensional decorative figure 15, 15a.

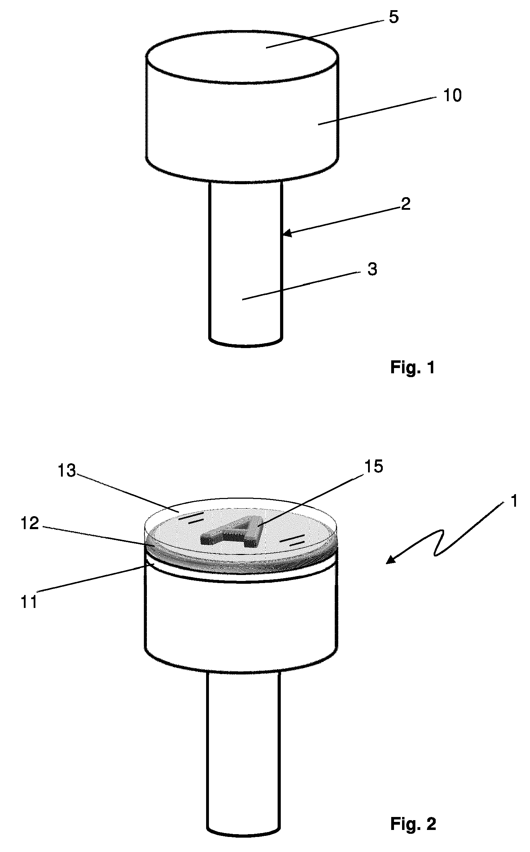

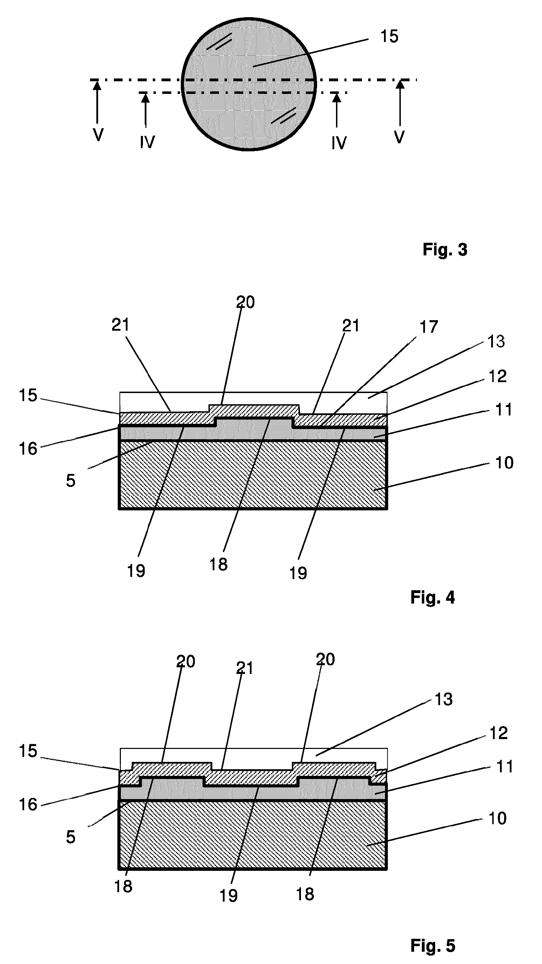

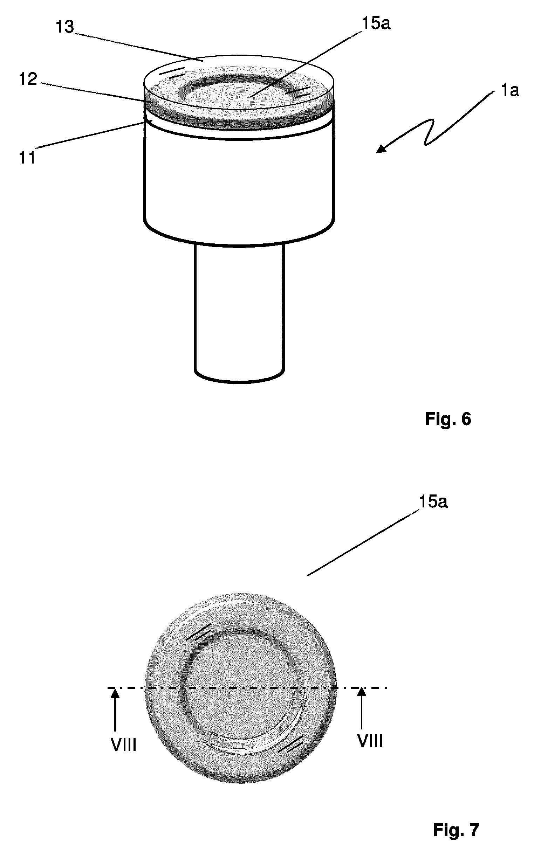

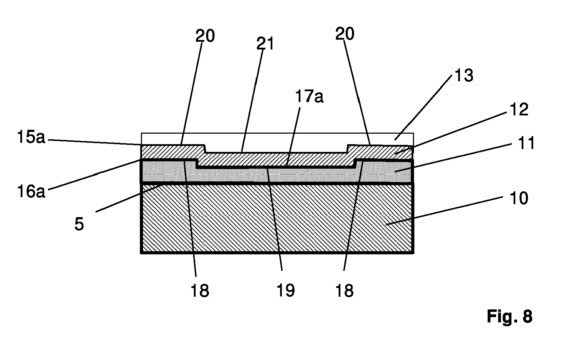

The three-dimensional impression 16, 16a includes a plurality of projections and/or cavities 18, 19 and is generally projecting or recessed in relation to a base surface 17, 17a of the base layer 11. In the embodiment of Figures 2 to 5, the three-dimensional impression 16 (consisting of a letter "A") projects with respect to the respective base surface 17. In the exemplary embodiment of Figures 6 to 8, the circular impression 16a is recessed with respect to the respective base surface 17a.

According to possible alternative embodiments of the present invention, the three-dimensional impression 16, 16a is obtainable by means of plastic deformation processing, such as moulding, using a mould on which a negative of the three-dimensional impression 16, 16a has been previously realized. For example, it is convenient to use a mould on which the negative 16, 16a of the three-dimensional impression is formed, for example by laser etching or marking. For example, for the realization of the mould, a technique known as "glass mastering" can be employed. Said mould can be conveniently pressed against the base layer 11.

Alternatively, according to other possible alternative embodiments of the present invention, the three-dimensional impression 16, 16a is obtained by machining with removal of material, for example milling, or by laser marking. In case the three-dimensional impression 16, 16a is obtained by moulding, the previous pre-drying step must ensure that the base layer 11 is sufficiently deformable, that is not completely solidified.

In case the three-dimensional impression 16, 16a is obtained by material removal, the preceding steps of lacquering or painting and pre-drying are optional. For example, material removal by milling or laser marking may be directly performed on the support 10.

Alternatively, always in the case in which the three-dimensional impression 16, 16a is obtained by material removal and/or by means of laser marking, after the step of lacquering or painting, in place of the pre-drying step, a step of complete drying is preferably performed, so that three-dimensional impression 16, 16a may be formed on a completely solidified base layer 11.

Laser etching or marking can also be used to obtain a plastic deformation in the base layer 11, for example a permanent superficial swelling, localized at the points struck by the laser radiation.

According to possible alternative embodiments of the present invention, in particular when the pre-drying and preparation steps of the three-dimensional impression 16, 16a are performed by means of plastic deformation, after the latter, the method comprises a step of complete drying, e.g. by applying ultraviolet rays to obtain the complete solidification of the base layer 11, by means of reticulation of the lacquer or paint.

The method subsequently includes the step of providing a metallization layer 12 comprising a three-dimensional decorative figure 15, 15a, respectively corresponding to the impression 16, 16a on the base layer 11 or directly on the support 10. The three-dimensional figure 15, 15a includes a plurality of reliefs and/or recesses 20, 21, respectively at the projections and/or cavities 18, 19.

According to possible embodiments of the present invention, the metallization with consequent formation of the layer 12 is realized by means of physical vapor deposition (PVD) technique, preferably by "sputtering" (cathode pulverization), which allows the formation of a metallized layer 12 of uniform and thin thickness. In possible alternative embodiments of the present invention, the thickness of the metallized layer 12 is between 50 and 70 nm (nanometres).

According to possible alternative embodiments of the present invention, as already described above, the metallization step is applied on a three-dimensional impression 16, 16a directly formed on the support 10, for example by laser marking.

Alternatively, possibly also by means of 3D printing techniques or other type of rapid prototyping process, a support 10 already comprising the impression 16, 16a can be formed. In this alternative embodiment of the invention, it is not necessary to perform the steps of application of the base layer 11 on the surface 5, pre-drying, realization of the three-dimensional impression 16, 16a on the support 10 or on the base layer 11 and drying.

According to another alternative embodiment of the present invention, the formation of the three-dimensional figure 15, 15a can take place without prior formation of the impression 16, 16a. In this variant, the method comprises the following succession of steps:
- application of the base layer 11 on the surface 5;
- complete drying of the base layer 11,
- metallization by PVD, for example sputtering, with the formation of a metallized layer 12 above the base layer 11;
- laser marking of the three-dimensional figure 15, 15a directly on the metallized layer 12.

The latter variant is particularly usable in case the support 10 is made of transparent material, because it allows to completely remove some parts of the metallized layer 12, by uncovering the transparent part below. With the aid of fluorescent or other lighting systems applied to the back of the support 10, the present embodiment thus allows to obtain luminous effects.

After the step of providing the metallization layer 12, there is a step of applying a final coating layer 13 on said metallization layer 12. The final layer 13 has protective and aesthetic functions and is typically transparent or semi-transparent so as to allow to view the underlying metallic layer 12 and in particular the three-dimensional decorative figure 15, 15a.

To obtain the solidification of the final layer 13, a final drying step is also provided. As for the base layer 11, also for the formation of the final layer it is possible to use a "UV coating" technique, with final drying by means of ultraviolet rays.

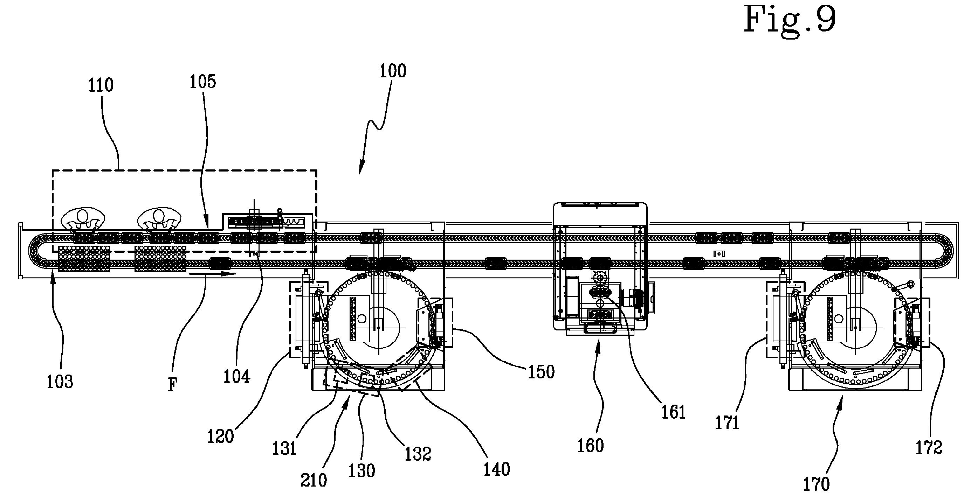

With reference to Figures 9 to 11, three different possible embodiments of an in-line machine for the treatment, for example the decoration, of small three-dimensional objects are indicated respectively by 100, 100a, 100b.

The machine 100, 100a, 100b can be used in particular for the decoration of the surface 5 of the support 10 of the three-dimensional semi-finished caps 2.

In general, the machine 100, 100a, 100b comprises a transfer line 103 having a transfer path 104 along which rough objects or in-processing objects or finished objects move according to the direction indicated by the arrow F.

A plurality of trays 105 is movable along the transfer line 103 from a feeding station 110. Each tray 105 is adapted to receive one or more semi-finished caps 2 to be treated.

The three different possible embodiments of the machine 100, 100a, 100b comprise respective painting and drying units 210, 210a, 210b, as detailed below.

With specific reference to Figure 9, along the transfer line 103, inside of the painting and drying unit 210, the following are provided in succession:
- a lacquering or painting station 120 to apply the base layer 11 by "UV coating";
- a pre-drying station 130 comprising a first infrared heater 131 and, downstream of this, a second ultraviolet heater 132;
- a plastic deformation processing station 140 of the base layer 11 to prepare a three-dimensional impression 16, 16a by moulding;
- an ultraviolet drying station 150 for the complete solidification of the base layer 11 comprising the three-dimensional impression 16, 16a by cross-linking.

Always with reference to Figure 9, along the transfer line 103, inside of the painting and drying unit 210, the following are provided in succession:
- a metallizing station 160 to prepare the three-dimensional figure 15, 15a above the three-dimensional impression 16, 16a by deposition of the metallization layer 12. In the metallization station 160, the metallization layer 12 is formed inside an application chamber 161, preferably a physical vapor deposition (PVD) chamber or a sputtering chamber;
- a finishing assembly 170 to apply the final coating layer 13 on said metallization layer 12. The finishing assembly 170 includes a station for final lacquering or painting 171 and a final ultraviolet drying station 172, substantially similar to the lacquering or painting station 120 and the drying station 150, respectively.

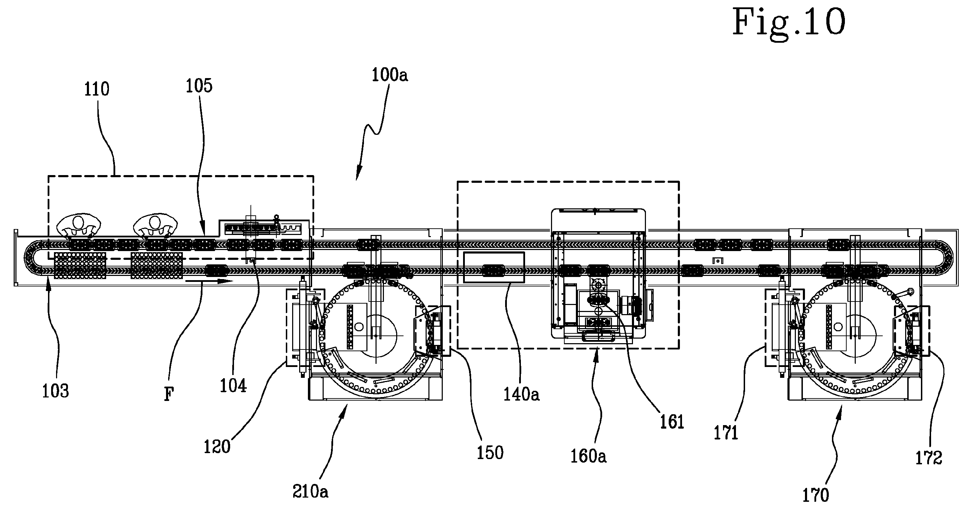

With specific reference to Figure 10, along the transfer line 103, inside of the painting and drying unit 210a, the following are provided in succession:
- a lacquering or painting station 120 to apply the base layer 11 by "UV coating";
- an ultraviolet drying station 150 for the complete solidification of the base layer 11.

Always with reference to Figure 10, along the transfer line 103, downstream of the painting and drying assembly 210a, there is a metallizing station 160a to prepare the three-dimensional figure 15, 15a. The metallizing station 160a comprises in succession:
- processing devices 140a to prepare three-dimensional impression 16, 16a, comprising for example a laser marking unit of the base layer 11, and/or one or more cutters or units for removal of other material;
- an application chamber 161, preferably a physical vapor deposition (PVD) chamber or a sputtering chamber, downstream of the processing means 140a for depositing the metallization layer 12 on the three-dimensional impression 16, 16a, so as to form the three-dimensional decorative figure 15, 15a.

Downstream of the metallizing station 160a, the finishing assembly 170 is provided.

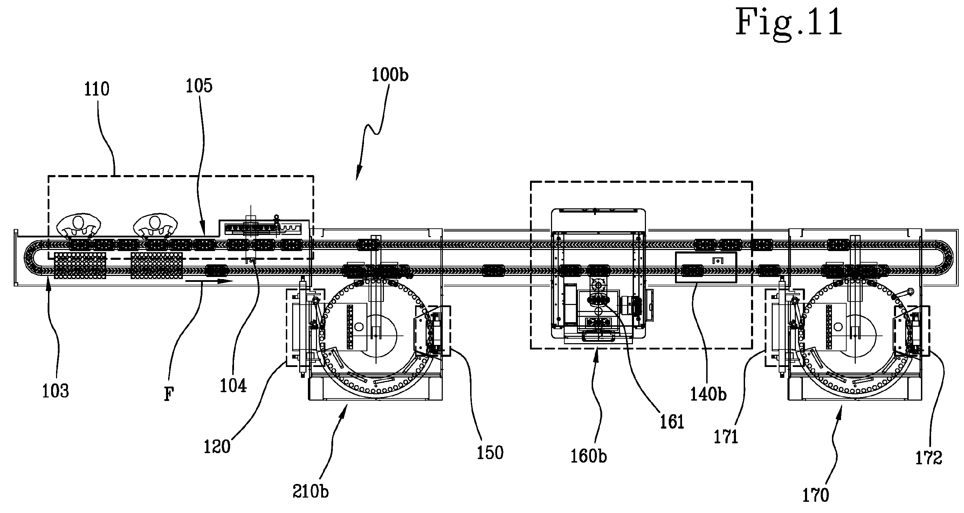

With specific reference to Figure 11, along the transfer line 103, the following are provided in succession:
- the coating unit and drying 210a;
- a metallizing station 160b.

The metallizing station 160b comprises in succession:
- an application chamber 161, preferably a physical vapor deposition (PVD) chamber or a sputtering chamber, to deposit the metallization layer 12 on the base layer 11;
- machining devices 140b to prepare the three-dimensional decorative figure 15, 15a on the metallization layer 12, comprising, for example, laser marking devices and/or one or more cutters or units for removal of other materials.

Downstream of the metallizing station 160b, the finishing assembly 170 is provided.

The latter alternative embodiment 100b allows for the formation of the three-dimensional figure 15, 15a without prior formation of the impression 16, 16a.

It is particularly usable, as previously mentioned, in case the support 10 is made of transparent material, because it allows to completely remove some parts of the metallized layer 12, by uncovering completely the transparent part below. In this way, it is therefore possible, with the aid of fluorescent or other lighting systems applied to the back of the support 10, to obtain written or luminous graphic patterns, visible also in poor lighting conditions.

The present invention allows to obtain a small three-dimensional object in which, in at least one surface, a decoration is highlighted, consisting of a three-dimensional shape, for example having the aspect of a hologram. This gives particular value to the object, not obtainable using known decoration methods.

## Claims

1. Method for treating small three-dimensional objects comprising the steps of:
- providing a semi-finished three-dimensional object (2) to be treated, comprising a support (10);
- realizing on at least one surface (5) of said support (10) a metallization layer (12);
- providing a three-dimensional impression (16, 16a) on at least one surface (5) of said support, said three-dimensional impression (16, 16a) comprising a plurality of projections and/or cavities (18, 19), whereby the metallization layer realized on said at least one surface presents a three-dimensional figure (15, 15a), comprising a plurality of reliefs and/or recesses (20, 21) respectively in correspondence of said projections and cavities (18, 19),
wherein said three-dimensional impression (16, 16a) is obtained by means of a laser marking treatment.

2. Method according to one or more of the preceding claims, wherein the metallization layer is realized by a physical vapor deposition (PVD) treatment.

3. Method according to claim 1 or 2, wherein the realization of said three-dimensional impression (16, 16a) occurs before the realization of said metallization layer (12).

4. Method according to claim 3, wherein said three-dimensional impression (16, 16a) is realized on a base layer (11) previously applied in contact with said at least one surface (5) of the support (10).

5. Method according to claim 3, wherein said three-dimensional impression (16, 16a) is obtained by plastic deformation of the base layer (11) for the effect of laser marking treatment.

6. Method according to claim 4 or 5, wherein said base layer is applied by a lacquering or painting operation and subsequent pre-drying, before providing said three-dimensional impression (16, 16a) on said base layer (11).

7. Method according to claim 1, further comprising the step of removing portions of said metallization layer (12) to obtain said three-dimensional figure (15, 15a).

8. Method according to claim 7, wherein the removing of portions of said metallization layer (12) to obtain said three-dimensional figure (15, 15a) is made by laser marking.

9. Machine for treating small three-dimensional objects (1, 1a) comprising a plurality of operational stations including:
- a power supply station (110) adapted to receive a semi-finished three-dimensional object (2) to be treated, said semi-finished three-dimensional object (2) comprising a support (10);
- a metallizing station (160, 160a, 160b) to prepare, on at least one surface (5) of said support (10), a metallization layer (12), with a substantially uniform thickness;
- processing devices (140a 140b) comprising a laser marking unit to provide, for providing, on said at least one surface (5), a three-dimensional impression (16, 16a) comprising a plurality of projections and/or cavities (18, 19), for which the metallization layer realized in the metallizing station presents a three-dimensional figure (15, 15a), comprising a plurality of reliefs and/or recesses (20, 21) respectively in correspondence of said projections and cavities (18, 19).

10. Machine according to claim 9, wherein said metallizing station (160, 160a, 160b) comprises a physical vapor deposition (PVD) chamber (161) for depositing said metallization layer (12).

11. Machine according to claim 9 or 10, wherein said processing devices (140a) operate upstream of said metallizing station (160, 160a, 160b).

12. Machine according to one or more of claim 9 to 11, wherein upstream of said metallizing station (160, 160a, 160b) a painting and drying assembly (210, 210a) is provided, including:
- a lacquering or painting station (120) for applying a base layer (11) in contact with said surface (5) of said support (10);
- a drying station (150) downstream of said lacquering or painting station (120).

13. Machine according to claim 12, wherein said laser marking unit operates upstream of the painting and drying assembly (210, 210a).

14. Machine according to claim 12 or 13, further comprising, between the lacquering or painting station (120) and the drying station (150), a processing station (140) for processing the base layer (11) to prepare said three-dimensional impression (16, 16a) by plastic deformation of said base layer (11).

15. Machine according to one or more of claims 9 to 14, wherein said processing devices (140b) operate downstream of said physical vapor deposition (PVD) chamber (161).
